# EUROPEAN PATENT APPLICATION

(11) **EP 2 348 244 A2**
(43) Date of publication of application: **27.07.2011**
(21) Application number: 11152098.7
(22) Date of filing: 25.01.2011
(51) Int. Cl.: F21K 99/00, F21Y 101/02

(54) **Light-emitting unit and illumination fixture using the same**

(30) Priority: 26.01.2010 JP 2010014820
(71) Applicant: Panasonic Electric Works Co., Ltd., Kadoma-shi Osaka 571-8686 (JP)
(72) Inventor: Katsuyuki, Kiyozumi, Hirakata Osaka (JP); Kuzuhara, Ikko, Himeji Hyogo (JP); Nishioka, Kouji, Kadoma Osaka (JP)
(74) Representative: Rüger, Barthelt & Abel Patentanwälte

(57) **Abstract**

[Object] To provide a light-emitting unit and an illumination device of higher productivity by comparatively-easily changing the white-based light emitted from a light-emitting device to the light of a different correlated color temperature while using a common light-emitting device.

[Means for Settlement] A light-emitting unit 10 has a light-emitting device 4 provided with an LED chip 1 serving a s a semiconductor light-emitting element and emitting white-based light and has a mounting substrate 5, the light-emitting device 4 being mounted on the mounting substrate 5; the light-emitting unit is composed of a wavelength converting part 6 separately formed so as to cover at least a light-emitting portion 4aa of the light-emitting device 4 emitting the white-based light, the wavelength converting part 6 emitting light having a correlated color temperature lower than the correlated color temperature of the white-based light from the light-emitting device 4.

## Description

### [Field of the Invention]

The present invention relates to a light-emitting unit provided with a light-emitting device having a semiconductor light-emitting element and to an illumination fixture using the same.

### [Background Art]

Recently, a light-emitting device for emitting white light having a semiconductor light-emitting element typified by an LED chip and a wavelength converting member, which converts the wavelength of the light emitted from the semiconductor light-emitting element, has been developed; and, such a light-emitting device is utilized, for example, in a backlight of a mobile phone, a flashlight, or decorative illumination. Under the circumstance that the light emission efficiency of semiconductor light-emitting elements is increasing, the light-emitting device consumes lower electric power and has a longer life compared with the illumination devices using conventional incandescent bulbs, halogen lamps, mercury lamps, fluorescent lamps, etc. as light sources. Therefore, the light-emitting device is expected as a light source of a general illumination device of a next generation.

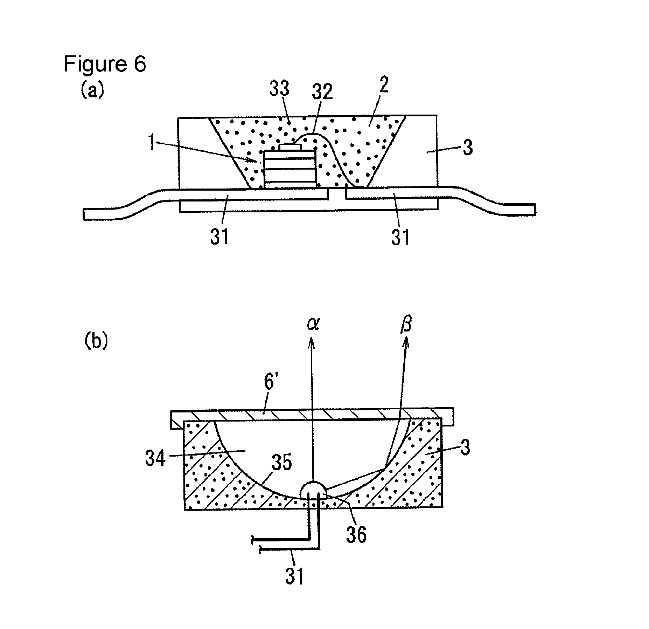

As a light-emitting device of this type, for example, as shown in Fig. 6 (a), a device having an LED chip 1 serving as a semiconductor light-emitting element, which emits blue light, and a wavelength converting member 2, which has a fluorescent substance 33 which absorbs the blue light from the LED chip 1 and emits yellow fluorescence, wherein the device emits white light by mixing the colors of the blue light from the LED chip 1 and the yellow light from the wavelength converting member 2 is known (for example, Patent Literature 1).

In the light-emitting device of Fig. 6 (a), a pair of first and second electric terminals 31 and 31 is provided in a package 3 of the light-emitting device. The LED chip 1 is mounted on and electrically connected to the first electric terminal 31, and an electrode on a surface of the LED chip 1 that is in the opposite side of the surface thereof mounted on the first electric electrode 31 is electrically connected to the second electric terminal 31 via a wire 32 so that they are configured to be able to supply electric power to the LED chip.

As another light-emitting device, a light-emitting device shown in Fig. 6 (b) having a light-emitting diode 36, which emits white light, and a wavelength converting part 6', which converts the white light emitted from the light-emitting diode 36 to the light of a different wavelength such as blue, green, yellow, or red so as to carry out color-tone adjustment and emit light, is also known (for example, Patent Literature 2).
In the light-emitting device shown in Fig. 6 (b), the light-emitting diode 36 is disposed in a concave portion of a package 3 so that the device is configured to be able to supply electric power to the light-emitting diode 36 by electric terminals 31. Moreover, the light-emitting device improves light utilization efficiency by the light α, which is emitted from the light-emitting diode 36 and transmits through the wavelength converting part 6' with the intermediation of a sealing part 34, and the light β, which is emitted from the light-emitting diode 36, with the intermediation of the sealing part 34, is reflected by a reflective material 35 provided on the surface of the concave portion, and then transmits through the wavelength converting part 6'.

### [Conventional Technique Literature]

### [Patent Literature]

[Patent Literature 1] Japanese Patent No. 2004-31989
[Patent Literature 2] JP 2009-86468 A

### [Disclosure of the Invention]

### [Problems to be solved by the Invention]

Incidentally, conventionally, a general illumination device using a fluorescent lamp or the like as a light source has been able to comparatively-easily change light to the light of a desired color temperature along blackbody radiation, for example, to a daylight color, daylight white, white, warm white, or an incandescent-bulb color by changing the fluorescent lamp.

On the other hand, the above described light-emitting device having the semiconductor light-emitting element has the properties that the electrostatic withstand voltage of the semiconductor light-emitting element is comparatively low and that the semiconductor light-emitting element is readily broken by handling. Therefore, in many cases, the device is disposed in an illumination device so that users do not directly touch the light-emitting device, etc., and it is difficult to replace the device. Therefore, the illumination device that uses the light-emitting device having the semiconductor light-emitting element as a light source is manufactured with the color temperature, color tone, and color rendering property of the light radiated from the illumination device being specified from the designing stage of the light-emitting device.

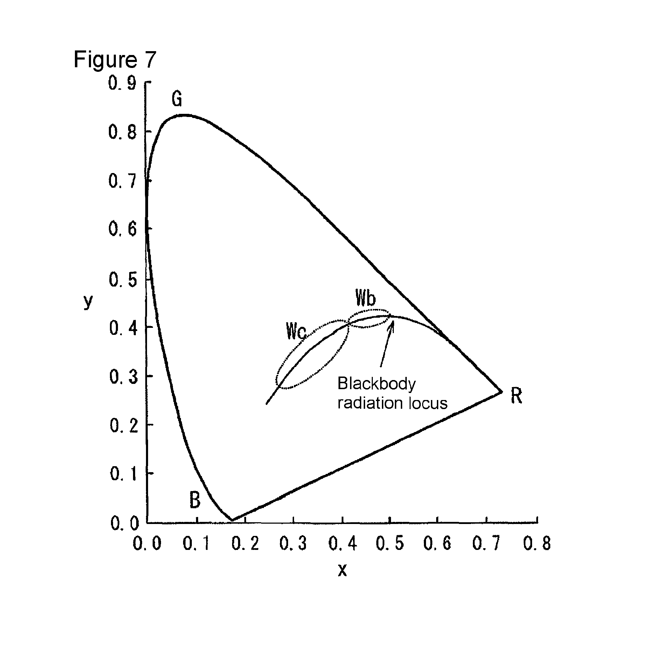

For example, in the above described light-emitting device according to above described Patent Literature 1, the color tone of the emitted light is determined by the light from the wavelength converting member 2, etc.; wherein, when this light-emitting device is applied to an illumination device that emits the light of white-based light (Wc) or incandescent-bulb-color based light (Wb) along a blackbody radiation locus exemplified in the chromaticity diagram of Fig. 7, the light-emitting device has to be manufactured with the fluorescent substance 33 per se and the content of the fluorescent substance 33 being individually adjusted for the color temperature which is determined in advance.

Moreover, in the case of the light-emitting device according to above described Patent Literature 2, in order to obtain white light, light-emitting devices which emit the light of blue, green, and red and have a complementary color-relation are used, and the light output of the light-emitting devices has to be adjusted. Therefore, since the light output of the light-emitting devices has to be controlled and adjusted for utilization in an illumination device, there are problems that the size of the whole illumination device is increased and that variation in the light output of the light-emitting devices has to be adjusted.

For example, examples of a manufacturing method of manufacturing illumination devices to which the light-emitting device of Patent Literature 1 is applied are shown in Fig. 8.

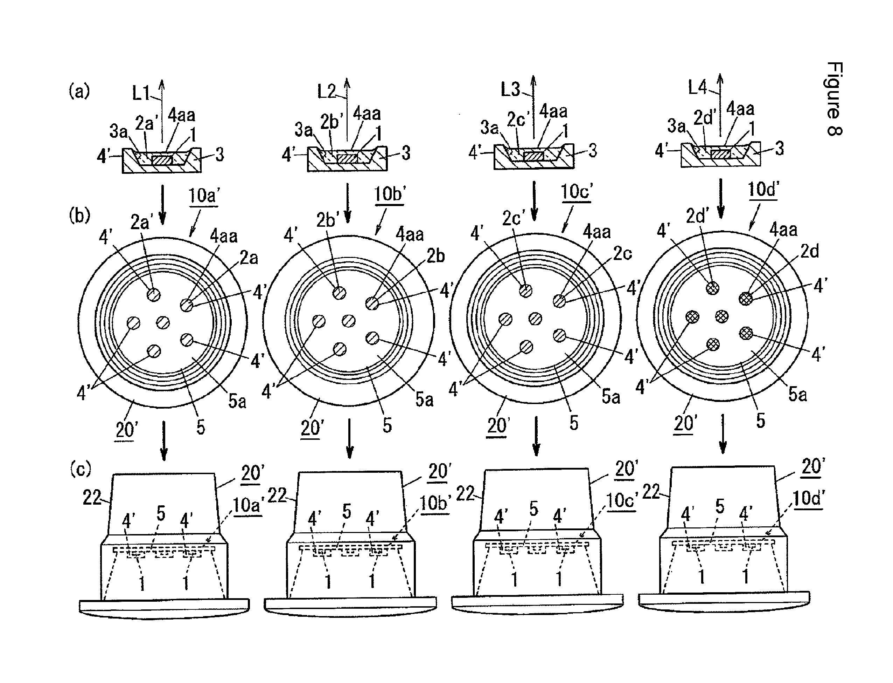

In Fig. 8 (a), cross sectional views of light-emitting devices 4' capable of emitting daylight white light L1, white light L2, warm white light L3, and incandescent-bulb-color light L4, respectively, are juxtaposed from the left side to the right side in the drawing. The light-emitting devices 4' have approximately-same configurations, and each of the light-emitting devices 4' has, in a concave portion 3a of a package 3, an LED chip 1 serving as a semiconductor light-emitting element and a wavelength converting member 2a', 2b', 2c', or 2d', which is excited by the blue light emitted from the LED chip 1 and emits yellow fluorescence. The wavelength converting members 2a', 2b', 2c', and 2d' of the light-emitting devices 4' are the members containing a fluorescent substance in a translucent resin, wherein the content of the fluorescent substance is mutually different. The closer the light-emitting devices 4' become from the daylight white light L1-side to the incandescent-bulb-color light L4-side, the higher the content of the fluorescent substance in the wavelength converting members 2a', 2b', 2c', and 2d'. Thus, in the light-emitting devices 4', the light volume of blue light from the LED chip 1, which emits light to outside, is absorbed by the fluorescent substance and reduced, and emission of the yellow light which has undergone wavelength conversion by the fluorescent substance by the absorption of the blue light is increased. Therefore, the light-emitting devices 4' can emit the light of different color temperatures such as the light of daylight white, white, warm white, and incandescent-bulb color. Therefore, the light-emitting devices 4 of the color temperatures required in the illumination devices 20' are designed and manufactured in advance for the illumination devices 20', respectively (Fig. 8 (b) and (c)).

Next, Fig. 8 (b) shows front views of the illumination devices 20 respectively having light-emitting units 10a', 10b', 10c', and 10d' on each of which six above described light-emitting devices 4' are mounted in a first surface 5a-side of a mounting substrate 5. Regarding the light-emitting units 10a', 10b', 10c', and 10d', when the plurality of light-emitting devices 4' separated respectively for the light of the color temperatures required by the illumination devices 20' (the daylight white light L1, the white light L2, the warm white light L3, and the incandescent-bulb-color light L4) are mounted on the first surfaces 5a of the mounting substrates 5 in accordance with the respective color temperatures, the light-emitting units 10a', 10b', 10c', and 10d' of mutually different four types can be manufactured.

Fig. 8 (c) shows the illumination devices 20', wherein the mutually different four types of light-emitting units 10a', 10b', 10c', and 10d' which are separated in accordance with the respective color temperatures (daylight white, white, warm white, and incandescent-bulb color) are housed in fixture main bodies 22, respectively.

As described above, upon manufacturing of the illumination devices 20' which emit the light of, for example, daylight white, white, warm white, and the incandescent-bulb color, respectively, the light-emitting devices 4' which emit the light of, for example, daylight color, daylight white, white, and warm white, respectively, are manufactured. Therefore, in order to emit light as the light of the different color temperatures emitted by the illumination devices 20', the devices have to be separately generated from the beginning of the light-emitting devices 4', which are the light sources.

Therefore, the production method of the illumination devices 20' has bad efficiency, for example, development, production, and stock management are required individually from the manufacturing stage of the light-emitting devices 4'. Note that, in order to cause the light-emitting device 4' to emit incandescent-bulb-color based light, yellow light emission has to be intensified more than white light; therefore, the state in which the concentration of the contained fluorescent substance becomes higher is obtained, and there is also a tendency that light flux is reduced.

As is clear from the manufacturing steps of the illumination devices 20' shown in Fig. 8, individual development, production, stock management, and so on of the various light-emitting devices 4' in accordance with different color temperatures are cumbersome; at the same time, the illumination device 20' per se has to be replaced in order to obtain the illumination device 20' of a different color temperature; and, the illumination devices 20' generate a problem that load is extremely imposed on users.

The present invention has been accomplished in view of the foregoing circumstances, and an object thereof is to provide a light-emitting unit of high productivity capable of comparatively easily changing the white-based light, which is emitted from a light-emitting device, to the light of a different correlated color temperature while using a common light-emitting device and to provide an illumination device using the same.

### [Means adapted to solve the Problems]

A first aspect of the present invention has a light-emitting unit having a light-emitting device provided with a semiconductor light-emitting element and emitting white-based light and a mounting substrate, the light-emitting device being mounted on the mounting substrate; the light-emitting unit having a wavelength converting part separately formed so as to cover at least a light-emitting portion of the light-emitting device emitting the white-based light, the wavelength converting part emitting light having a correlated color temperature lower than the correlated color temperature of the white-based light from the light-emitting device.

According to the present invention, the wavelength converting part separately formed so as to cover at least the light-emitting portion of the light-emitting device emitting the white-based light, the wavelength converting part emitting light having a correlated color temperature lower than the correlated color temperature of the white-based light from the light-emitting device; therefore, the white-based light emitted from the light-emitting device can be changed comparatively easily to the light having a different correlated color temperature while using the common light-emitting device, and the light-emitting unit of higher productivity can be obtained.

More specifically, the light-emitting unit can emit the light having a lower correlated color temperature by the separately-formed wavelength converting part based on the white-based light radiated from the light-emitting device.

Therefore, even when, for example, only the light-emitting units provided with the light-emitting devices which emit daylight white light are commonly manufactured, the light-emitting unit can efficiently emit the light of white, warm white, or incandescent-bulb color only by replacing the wavelength converting part.

Therefore, the light-emitting unit is not required to subject the light-emitting devices of different correlated color temperatures to individual development, production, stock management, etc.; the light-emitting unit is excellent in reduction of development man-hours and simplification of stock management of the light-emitting devices of the different correlated color temperatures; and, the light-emitting unit can be formed with good productivity.

Particularly, the light-emitting unit provided with the light-emitting device which emits white-based light is used as a common basic body; the light-emitting units having different correlated color temperatures, color tones, and color rendering properties can be formed in a later step upon manufacturing of the light-emitting units; and the light-emitting units of excellent productivity can be provided. More specifically, the light-emitting devices having the different correlated color temperatures, color tones, and color rendering properties are not required to be individually subjected to development, production, and stock management respectively for the light-emitting units of the different color tones; and the units are excellent in reduction of the development man-hours and simplification of stock management. Moreover, the light-emitting unit in which the light-emitting device is mounted on the mounting substrate also does not require individual development, production, stock management, etc. of color tones, color rendering properties, etc.; and variation in quality can be also reduced.

According to a second aspect of the present invention, in the first aspect of the present invention, the white-based light from the light-emitting device is within the range of 4500 K to 7000 K.

According to this aspect of the present invention, the white-based light from the light-emitting device is within the range of 4500 K to 7000 K; therefore, for example, when white-based light of daylight color, daylight white, white, etc. is emitted from the light-emitting device, the light of warm white or the incandescent-bulb color can be radiated from the light-emitting unit with good efficiency by the wavelength converting part.

A third aspect of the present invention has: a fixture main body provided with a light-emitting unit having a light-emitting device and a mounting substrate, the light-emitting device being mounted on the substrate, the light-emitting device having a semiconductor light-emitting element and emitting white-based light; a translucent panel or a globe cover allowing transmission of at least part of the light from the light-emitting unit; and a wavelength converting part separately formed so as to cover at least a light-emitting portion of the light-emitting device emitting the white-based light, the wavelength converting part emitting light having a correlated color temperature lower than the correlated color temperature of the white-based light from the light-emitting device.

According to this aspect of the present invention, the invention has: the fixture main body provided with the light-emitting unit having the light-emitting device and the mounting substrate, the light-emitting device being mounted on the substrate, the light-emitting device having the semiconductor light-emitting element and emitting white-based light; the translucent panel or the globe cover allowing transmission of at least part of the light from the light-emitting unit; and the wavelength converting part separately formed so as to cover at least the light-emitting portion of the light-emitting device emitting the white-based light, the wavelength converting part emitting light having the correlated color temperature lower than the correlated color temperature of the white-based light from the light-emitting device; therefore, the white-based light emitted from the light-emitting device can be comparatively easily changed to the light having the correlated color temperature while using the common light-emitting device, and an illumination device of higher productivity can be obtained.

According to a fourth aspect of the present invention, in the third aspect of the present invention, has the translucent panel or the globe cover provided with an application part, the wavelength converting part being applied on a surface of the application part.

According to this aspect of the present invention, the translucent panel or the globe cover is provided with the application part having the surface on which the wavelength converting part is applied; therefore, compared with the area of the above described light-emitting portion of the light-emitting device, the wavelength converting part can be formed on the larger surface of the translucent panel or the globe cover.

Therefore, the illumination device can form the wavelength converting part having good controllability of color tones by a comparatively simple configuration of only applying the wavelength converting part. Moreover, the illumination device can arbitrarily and freely change the radiated white-based light to the light having a different correlated color temperature comparatively easily by a simple structure of only replacing the translucent panel or the globe cover.

Particularly, the wavelength converting part is provided on the surface of the translucent panel or the globe cover so as to be separated from the light-emitting device, and the wavelength converting part is spaced apart from the light-emitting portion of the light-emitting device; therefore, thermal deterioration of the wavelength converting part caused by the heat from the light-emitting device along with lighting of the light-emitting device does not easily occur. Moreover, since the wavelength converting part is spaced apart from the light-emitting portion of the light-emitting device, the heat generation caused by wavelength conversion can be reduced. Therefore, compared with the illumination device in which the wavelength converting part is formed on the light-emitting portion of the light-emitting device, the illumination device of stronger light flux can be obtained.

Moreover, more uniform transmitted light can be emitted from the wavelength converting part by adjusting: the shape of the globe cover, the separated distance between the light-emitting device and the globe cover, and the outgoing angle of the light emitted from the light-emitting portion of the light-emitting device.

According to a fifth aspect of the present invention, in the third aspect of the present invention, the translucent panel or the globe cover has a surface, a sheet part of the wavelength converting part being provided on the surface.

According to this aspect of the present invention, the translucent panel or the globe cover as the surface on which the sheet part of the wavelength converting part is provided; therefore, compared with the area of the light-emitting portion in the light-emitting device, the wavelength converting part can be formed on a larger surface of the translucent panel or the globe cover.

Therefore, the illumination device can form the wavelength converting part having good controllability of color tones by a comparatively simple configuration of only providing the sheet part of the wavelength converting part. Moreover, the illumination device can arbitrarily and freely change the radiated white-based light to the light having a different correlated color temperature comparatively easily by a simple structure of only replacing the translucent panel, the globe cover, or the wavelength converting part.

Particularly, the wavelength converting part is provided on the surface of the translucent panel or the globe cover so as to be separated from the light-emitting device, and the wavelength converting part is spaced apart from the light-emitting portion of the light-emitting device; therefore, thermal deterioration of the wavelength converting part caused by the heat from the light-emitting device along with lighting of the light-emitting device does not easily occur. Moreover, since the wavelength converting part is spaced apart from the light-emitting portion of the light-emitting device, the heat excited along with wavelength conversion can be reduced. Therefore, compared with the illumination device in which the wavelength converting part is formed on the light-emitting portion of the light-emitting device, the illumination device of stronger light flux can be obtained.

Moreover, more uniform transmitted light can be emitted from the wavelength converting part by adjusting: the shape of the globe cover, the separated distance between the light-emitting device and the globe cover, and the outgoing angle of the light emitted from the light-emitting portion of the light-emitting device.

According to a sixth aspect, in the fourth aspect of the present invention, the application part is provided with a removed part of the wavelength converting part, the removed part allowing transmission of the white-based light from the light-emitting device; and the removed part forms at least one of a figure and a pattern.

According to this aspect of the present invention, the application part is provided with the removed part of the wavelength converting part which allows transmission of the white-based light from the light-emitting device, and the removed part forms at least one of the figure or the pattern; therefore, light emission of an arbitrary figure or a pattern can be obtained by utilizing the removed part of the wavelength converting part, and the illumination device excellent in design can be provided.

According to a seventh aspect, in the fifth aspect of the present invention, the sheet part is provided with a removed part of the wavelength converting part, the removed part allowing transmission of the white-based light from the light-emitting device; and the removed part forms at least one of a figure and a pattern.

According to this aspect of the present invention, the sheet part is provided with the removed part of the wavelength converting part which allows transmission of the white-based light from the light-emitting device, and the removed part forms at least one of the figure or the pattern; therefore, light emission of an arbitrary figure or pattern can be obtained by utilizing the removed part of the wavelength converting part, and the illumination device excellent in design can be provided.

According to an eighth aspect, in the fourth or fifth aspect of the present invention, the translucent panel or the globe cover has a surface provided with a fluorescent member emitting fluorescence by the color tone of the light from the wavelength converting part and the light from the light emitting device, the fluorescence having a color tone different from the color tone of the light; and the fluorescent member forms at least one of a figure and a pattern.

According to this aspect of the present invention, the translucent panel or the globe cover has the surface provided with the fluorescent member emitting fluorescence by the color tone of the light from the wavelength converting part and the light from the light emitting device, the fluorescence having a color tone different from the color tone of the light; and the fluorescent member forms at least one of the figure and the pattern; therefore, arbitrary light emission of the figure or light emission of the pattern can be obtained by the fluorescent member, and the illumination device excellent in design can be provided.

Moreover, the globe cover can obtain, for example, the light emission of an arbitrary figure or pattern by exciting and emitting light by the fluorescent member.

### [Effect of the Invention]

In the first aspect of the present invention, the wavelength converting part is provided, wherein the wavelength converting part is separately formed so as to cover at least the light-emitting portion of the light-emitting device and emits the light having the correlated color temperature lower than the correlated color temperature of the blackbody radiation of the white-based light emitted from the light-emitting portion of the light-emitting device; therefore, there is a prominent effect that the light-emitting unit of higher productivity can be provided by comparatively-easily changing the white-based light emitted from the light-emitting device to the light of the different correlated color temperature while using the common light-emitting device.

Moreover, in the third aspect of the present invention, the fixture main body is provided with the light-emitting unit having the light-emitting device and the mounting substrate, the light-emitting device being mounted on the substrate, the light-emitting device having the semiconductor light-emitting element and emitting white-based light; the translucent panel or the globe cover allows transmission of at least part of the light from the light-emitting unit; and the wavelength converting part separately formed so as to cover at least the light-emitting portion of the light-emitting device emitting the white-based light, the wavelength converting part emitting light having the correlated color temperature lower than the correlated color temperature of the white-based light from the light-emitting device; there is a prominent effect that the illumination device of higher productivity can be provided by comparatively-easily changing the white-based light emitted from the light-emitting device to the light of the different correlated color temperature while using the common light-emitting device.

### [Brief Description of the Drawings]

[Fig. 1] Fig. 1 shows a light-emitting unit of a first embodiment, wherein Fig. 1 (a) shows a front view, and Fig. 1 (b) shows a schematic cross sectional view of AA of Fig. 1 (a).
[Fig. 2] Fig. 2 is an explanatory drawing explaining manufacturing steps of illumination devices using the above described light-emitting unit.
[Fig. 3] Fig. 3 is a step explanatory drawing explaining manufacturing steps of an illumination device of a second embodiment.
[Fig. 4] Fig. 4 shows illumination devices of a third embodiment, wherein Fig. 4 (a) shows a schematic cross sectional view of the basic illumination device, and Fig. 4 (b) is a schematic cross sectional view of the illumination device which radiates the light having a correlated color temperature different from that of Fig. 4 (a).
[Fig. 5] Fig. 5 shows a front view of the illumination device.
[Fig. 6] Fig. 6 shows conventional light-emitting devices, wherein Fig. 6 (a) is a cross sectional view of the light-emitting device, and Fig. 6 (b) is a cross sectional view of the other light-emitting device.
[Fig. 7] Fig. 7 is an explanatory diagram explaining the light emitted by the light-emitting device shown for reference.
[Fig. 8] Fig. 8 shows manufacturing steps of illumination devices for comparison with the present application.

### [Best Modes for Carrying Out the Invention]

### (First Embodiment)

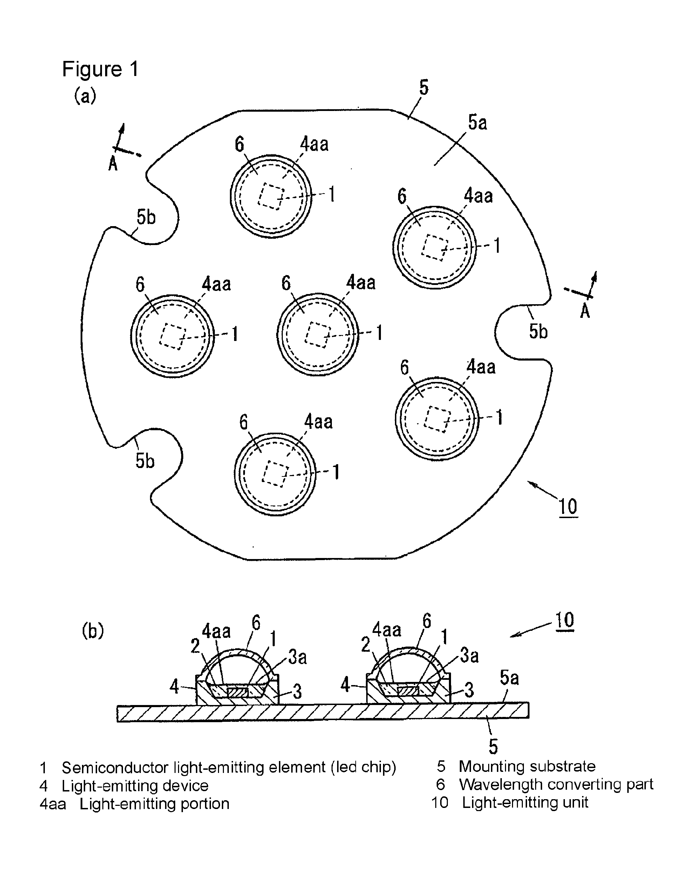

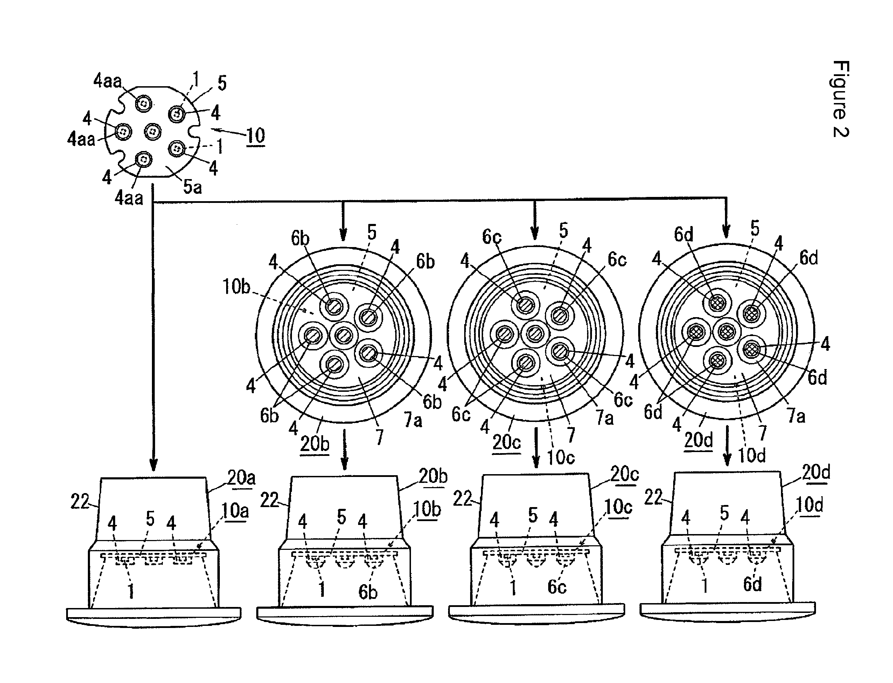

A light-emitting unit of the present embodiment and an illumination fixture using the same will be explained by using Fig. 1 and Fig. 2. Note that, in Fig. 1 and Fig. 2, the same constituent elements are denoted by the same reference numerals.

The light-emitting unit 10 of the present embodiment shown in Fig. 1 has light-emitting devices 4 and a mounting substrate 5 on which the light-emitting devices 4 are mounted in a first surface 5a-side, wherein the light-emitting device 4 has an LED chip 1 serving as a semiconductor light-emitting element and a wavelength converting member 2 containing, in a translucent resin, a fluorescent substance which absorbs blue light emitted from the LED chip 1 and emits yellow-based fluorescence serving as a complementary color, and the light-emitting device 4 emits white-based mixed light (for example, standard light (D65)).

Particularly, the light-emitting unit 10 has wavelength converting parts 6 each of which is separately formed so as to cover at least a light-emitting portion 4aa of the light-emitting device 4, which emits white-based light, and emits the light of a correlated color temperature lower than that of the white-based mixed-color light emitted from the light-emitting device 4. Herein, the correlated color temperature represents a closest blackbody temperature even in the case in which the color of the light source is not on the blackbody radiation locus and does not completely match therewith.

Note that, as shown in Fig. 1 (b), the wavelength converting part 6 is separately formed so as to cover at least the light-emitting portion 4aa of the light-emitting device 4, which emits white-based light, and is disposed so as to be spaced away from the light-emitting portion 4aa of the light-emitting device 4.

Herein, the light-emitting unit 10 of Fig. 1 (a) is composed by mounting a plurality of (herein, six) light-emitting devices 4 on the first surface 5a-side of the mounting substrate 5. Note that the outer peripheral part of the mounting substrate 5 is provided with cut-away portions 5b utilized upon fixation into a later-described illumination device 20.

More specifically, in the light-emitting unit 10, the six light-emitting devices 4 are mounted in the first surface 5a-side of the flat plate-shaped mounting substrate 5. The LED chip 1 serving as a semiconductor light-emitting element composed of a nitride semiconductor material which emits blue light (for example, blue light having an emission peak wavelength of 460 nm) is disposed in a concave portion 3a of each of the light-emitting devices 4. The LED chip 1 is electrically connected to a lead frame (not shown) extending from the interior of the concave portion 3a of the package 3 of the light-emitting device 4 to the outside of a package 3. The LED chip 1 is covered with a wavelength converting member 2 containing, in a translucent resin (for example, silicone resin), a fluorescent substance (for example, (Ba_{0.05}Sr_{0.93}Eu_{0.02})₂SiO₄), which absorbs the blue light from the LED chip 1 and emits fluorescence based on yellow serving as a complementary color. The light-emitting device 4 is configured so as to be able to supply electric power to the LED chip 1 by electrically connecting a conductor pattern (not shown) formed in the first surface 5a-side of the mounting substrate 5 with the lead frame by soldering or the like. When electric power is supplied to the LED chip 1 of the light-emitting device 4 from outside, the LED chip 1 emits blue light, and the fluorescent substance of the wavelength converting member 2 absorbs the blue light and emits yellow light. Daylight white light having a correlated color temperature of the blackbody radiation with white-based light of about 5000 K is emitted from the light-emitting portion 4aa of the light-emitting device 4 by color mixture of the blue light from the LED chip 1 transmitted through the wavelength converting member 2 and the yellow light from the fluorescent substance of the wavelength converting member 2.

Herein, when the light-emitting unit 10 is to radiate the light of white, warm white, or an incandescent-bulb color having a lower correlated color temperature than daylight white from the light-emitting portion 4aa of the light-emitting device 4, in the light-emitting unit 10, the wavelength converting part 6 can be disposed so as to be spaced apart from the light-emitting portion 4aa of the light-emitting device 4, wherein the wavelength converting part 6 is separately formed so as to cover the light-emitting portion 4aa of the light-emitting device 4 and is formed to have a dome shape and contain, in a translucent resin (for example, a silicone resin), a fluorescent substance (for example, (Ba_{0.05}Sr_{0.93}Eu_{0.02})₂SiO₄), which absorbs the blue light from the LED chip 1 and emits yellow-based fluorescence serving as a complementary color. Herein, when the wavelength converting part 6 increases the concentration of the fluorescent substance in the resin, the correlated color temperature of the light radiated from the wavelength converting part 6 can be further reduced from the white-side to the incandescent-bulb-color side. Note that the wavelength converting part 6 formed to have the dome shape may be fixed by a fitting part, which is not shown, or may be fixed by an adhesive agent composed of a silicone resin or the like so as to cover the light-emitting portion 4aa of the light-emitting device 4.

Thus, as shown in Fig. 2, the light-emitting units 10 of only one type are commonly produced until the point at which the light-emitting devices 4 are mounted on the first surface 5a of the mounting substrate 5; and the light-emitting units 10 can be made into the light-emitting units 10 that obtain the light of two or more types of color temperatures only by providing/not providing the wavelength converting parts 6 or replacing the wavelength converting parts 6 with wavelength converting parts 6b, 6c, or 6d for emitting the light of a target color temperature. In Fig. 2, planar views of mutually different illumination devices 20b, 20c, and 20d are shown with the arrows from the light-emitting unit 10, and cross sectional schematic views of the illumination devices 20b, 20c, and 20d are shown with the arrows from the planar views.

More specifically, if the light-emitting device 4 is not provided with the cap-shaped wavelength converting part 6, the light-emitting unit 10 of the present embodiment can cause the light, which is emitted from the light-emitting unit 10, to be the light of, for example, a correlated color temperature of the color tone corresponding to daylight white. Moreover, in a light-emitting unit 10b, when the light-emitting portion 4aa of the light-emitting device 4, which emits the light of daylight white, is covered with the separately-formed cap-shaped wavelength converting part 6b so that the wavelength converting part is spaced apart therefrom, the light-emitting unit 10b can cause the light-emitting device 4 to emit white light having a lower correlated color temperature than the white-based (daylight white) basic light. Moreover, in a light-emitting unit 10c, when the light-emitting portion 4aa of the light-emitting device 4, which emits the light of daylight white, is covered with the separately-formed cap-shaped wavelength converting part 6c so that the wavelength converting part is spaced apart therefrom, the light-emitting unit 10c can cause the light-emitting device 4 to emit the light of warm white having a lower correlated color temperature than the white-based (daylight white) basic light. Similarly, in a light-emitting unit 10d, when the light-emitting portion 4aa of the light-emitting device 4, which emits the light of daylight white, is covered with the separately-formed cap-shaped wavelength converting part 6d so that the wavelength converting part is spaced apart therefrom, the light-emitting unit 10d can cause the light-emitting device 4 to emit the light of an incandescent-bulb color having a lower correlated color temperature than the white-based (daylight white) basic light.

The thus-formed light-emitting units 10 can be disposed in fixture main bodies 22 of the illumination devices 20, respectively. When the light emission colors of different correlated color temperatures are desired to be arbitrarily radiated from the illumination devices 20, the wavelength converting parts 6 of a plurality of types which emit the light of lower correlated color temperatures than the white-based light emitted from the light-emitting portions 4aa of the light-emitting devices 4 can be prepared. Note that, the white-based light radiated from the light-emitting devices 4 is not limited only to the light having a correlated color temperature of around 5000 K, and it can be set so as to emit the light of the chromaticity higher than that of the correlated color temperature set as the illumination device 20.

Hereinafter, the constitutions used in the light-emitting unit 10 and the illumination device 20 of the present embodiment will be described in detail.

Each of the semiconductor light-emitting elements used in the light-emitting devices 4 of the light-emitting unit 10 of the present embodiment is a semiconductor element which can emit light when electric power is supplied thereto. The light radiated by the semiconductor light-emitting element may be, for example, blue light that has strong energy among visible light. However, the light is not limited only to the blue light. When white-based light is to be emitted by the light emitted from the LED chip 1 serving as the semiconductor light-emitting element and the light emitted from the wavelength converting member 2, the light of ultraviolet rays or other wavelengths may be used for efficiently exciting the wavelength converting member 2. The LED chip 1 serving as the semiconductor light-emitting element is, for example, a substrate having a gallium nitride-based compound semiconductor layer having pn junction on a crystal growth substrate such as: sapphire substrates, spinel substrates, gallium nitride substrates, zinc oxide substrates, and silicon carbide substrates.

Note that, as the LED chip 1, an LED chip 1, in which a semiconductor layer is formed on an insulating substrate, and positive and negative electrodes are formed on the same surface-side of the semiconductor layer, may be used, or an LED chip 1, in which an electrically-conductive substrate is used, and positive and negative electrodes are formed respectively in the both surface-sides in the thickness direction of the LED chip 1, may be used.

The LED chip 1, in which the positive and negative electrodes are provided in the same surface-side, can be flip-chip-mounted by using metal bumps such as metal bumps on a bottom surface of the concave portion 3a of the package 3 of the light-emitting device 4 having a surface on which a pair of electrically-conductive patterns is formed. Meanwhile, the LED chip 1, in which the positive and negative electrodes are respectively provided in the both surface-sides in the thickness direction of the LED chip 1, causes one conductor pattern of a pair of conductor patterns formed on the bottom surface of the concave portion 3a of the package, in which the LED chip 1 is to be mounted, to be electrically connected with one of the above described electrodes of the LED chip 1 via an electrically-conductive member (for example, AuSn or Ag paste) by die bonding. The other electrode of the LED chip 1 in the light-emitting surface-side can be electrically connected with the other conductor pattern via a wire (for example, an aluminum wire or a gold wire).

In the light-emitting device 4 of the light-emitting unit 10 of the present embodiment, one LED chip 1 is mounted as the semiconductor light-emitting element in the concave portion 3a of the package 3; however, the number of the LED chip 1 is not limited to one, and a plurality of LED chips can be used. In that case, the LED chips 1 may be arbitrarily electrically connected in series, parallel, or series parallel.

Up to the present moment, it is difficult to obtain sufficient light output equivalent to the light source of a conventional general illumination device such as a fluorescent lamp by the light-emitting device 4 using the LED chip 1 which is a single semiconductor light-emitting element. Therefore, the plurality of light-emitting devices 4 are disposed in the first surface 5a-side of the mounting substrate 5 so as to form the light-emitting unit 10. In this case, it is difficult to uniformize the color tones of the light emitted from the light-emitting devices 4; therefore, in the light-emitting unit 10 of the present embodiment, the productivity of the light-emitting unit 10 or the illumination device 20 using the light-emitting unit 10 can be significantly improved by mounting the light-emitting devices 4, which emit white-based light, in the first surface 5a-side of the mounting substrate 5 in advance and controlling the correlated color temperatures by the wavelength converting parts 6 of a plurality of types.

Next, as the wavelength converting member 2 used in the light-emitting device 4 of the light-emitting unit 10 of the present embodiment, a member containing, in a translucent resin, glass, or the like, a fluorescent substance which converts the wavelength of at least part of the light from the LED chip 1 can be used for radiating white-based light from the light-emitting portion 4aa of the light-emitting device 4. Examples of the employable fluorescent substance used in the wavelength converting member 2 include: nitride-based fluorescent substances such as (Sr, Ca, Mg)AlSiN₃ activated by Eu and (Sr, Ca)₂Si₅N₈ activated by Eu; aluminate-based fluorescent substances such as Y₃Al₅O₁₂ activated by Ce and Tb₃Al₅O₁₂ activated by Ce; silicate-based fluorescent substances such as Ba₂SiO₄ activated by Eu and (Sr, Ba, Ca)₂SiO₄ activated by Eu; and faro borate-based fluorescent substances such as Ca₂BO₃C₁₂. The fluorescent substance used in the wavelength converting member 2 is not limited to a yellow fluorescent substance, and white light can be obtained even when, for example, a red fluorescent substance and a green fluorescent substance are added thereto.

Next, the package 3 used in the light-emitting device 4 of the light-emitting unit 10 of the present embodiment is capable of protecting the LED chip 1 serving as the semiconductor light-emitting element and the wavelength converting member 2, and the package 3 can be formed of a resin, ceramic, or the like. In order to emit the light from the LED chip 1 and the wavelength converting member 2 in a predetermined direction with good efficiency, the package 3 having an inner surface provided with the concave portion 3a having a high reflectivity with respect to the light from the LED chip 1 and the wavelength converting member 2 is preferably used. However, the package 3 is not necessarily required to have the concave portion 3a. Therefore, depending on the material or the structure of the package 3, the entirety of the light-emitting device 4 sometimes functions as a light-emitting portion 4aa. Moreover, the light-emitting device 4 is not necessarily mounted on the first surface 5a-side of the mounting substrate 5, but may be mounted in a second surface-side opposite to the first surface 5a of the mounting substrate 5. In this case, the light-emitting device 4 can have the structure of the package 3 that can be mounted in the second surface-side so that white-based light can be emitted from a through-hole (not shown) of the mounting substrate 5.

On the mounting substrate 5 used in the light-emitting unit 10 of the present embodiment, the light-emitting devices 4 can be mounted in the first surface 5a-side. A substrate in which a pair of conductor patterns (not shown) is provided on the first surface 5a may be utilized as the mounting substrate 5 so that an electric power supply path of the light-emitting devices 4 is formed. Such a mounting substrate 5 may use, for example: a metal substrate using a Fe material, a Cu material, an Al material, or the like; a ceramic substrate of aluminum nitride, alumina, or the like; or a glass epoxy resin substrate. When the mounting substrate 5 has electric conductivity, an insulating layer can be arbitrarily formed in the first surface 5a-side of the mounting substrate 5 in order to prevent short-circuit with the conductor patterns. When the ceramic substrate of aluminum nitride is used as the mounting substrate 5, thermal conductivity is high compared with that of the glass epoxy resin substrate, etc., the heat generated in lighting of the light-emitting devices 4 can be dissipated to outside with good efficiency, and the heat dissipating performance of the light-emitting unit 10 can be enhanced.

Note that the light-emitting unit 10 of the present embodiment uses the flat plate-shaped mounting substrate 5 for mounting the light-emitting devices 4; however, a mounting substrate 5 having a reflector, which reflects the light from the light-emitting devices 4, at a peripheral part of the mounting substrate 5 may be used.

In the illumination device 20 housing the light-emitting unit 10 of the present embodiment, in the planar views shown in Fig. 2, a cover part 7 having reflector parts 7a, which reflect the light from the light-emitting devices 4, at the respective peripheral parts of the light-emitting devices 4 is suitably provided in the first surface 5a-side of the mounting substrate 5.

The wavelength converting part 6 used in the light-emitting unit 10 of the present embodiment emits the light having a correlated color temperature lower than that of the white-based light emitted from the light-emitting portion 4a of the light-emitting device 4. The wavelength converting part 6 can be composed of a translucent material such as a silicone resin, an epoxy resin, an acrylic resin, or glass containing the fluorescent substance that, for example, absorbs blue light components from among the white-based light from the light-emitting device 4 and radiates yellow light.

The thickness of the wavelength converting part 6 can be variously selected in accordance with a target correlated color temperature of the light radiated from the light-emitting unit 10 or the intensity of the white-based light emitted from the light-emitting device 4. The fluorescent substance contained in the translucent material of the wavelength converting part 6 can be, for example, 50 weight% or less, although it is different depending on: the light emission efficiency of the fluorescent substance, the thickness of the wavelength converting part 6, the target correlated color temperature of the light radiated from the light-emitting device 4, and the intensity of the white-based light radiated from the light-emitting device 4.

Examples of the employable fluorescent substance used in the wavelength converting part 6 include: nitride-based fluorescent substances such as (Sr, Ca, Mg)AlSiN₃ activated by Eu and (Sr, Ca)₂Si₅N₈ activated by Eu; aluminate-based fluorescent substances such as Y₃Al₅O₁₂ activated by Ce and Tb₃Al₅O₁₂ activated by Ce; silicate-based fluorescent substances such as Ba₂SiO₄ activated by Eu and (Sr, Ba, Ca)₂SiO₄ activated by Eu; and faro borate-based fluorescent substances such as Ca₂BO₃C₁₂. The fluorescent substance used in the wavelength converting part 6 is not limited to a yellow fluorescent substance, and, for example, a red fluorescent substance and a green fluorescent substance are added thereto.

Herein, if the light-emitting portion 4aa of the light-emitting device 4 and the wavelength converting part 6 are disposed so that they are not spaced apart from each other, the wavelength converting part 6 covering the LED chip 1 is heated along with lighting of the light-emitting device 4. The wavelength converting part 6 has a temperature quenching characteristic, wherein light output is reduced along with increase in the temperature; therefore, the wavelength converting part 6 cannot entirely-uniformly emit light and has a tendency that the light emission efficiency of the wavelength converting part 6 is reduced.

On the other hand, when the light-emitting portion 4aa of the light-emitting device 4 and the wavelength converting part 6 are spaced apart from each other, heating of the wavelength converting part 6 caused along with lighting of the LED chip 1 can be suppressed, and reduction in the light emission efficiency can be suppressed.

Incidentally, regarding the light-emitting unit 10 of the present embodiment, the light-emitting unit 10 which emits light of a different color tone can be formed by replacing the separately-formed wavelength converting part 6, wherein the light-emitting unit 10 of one type serves as a basic. In this case, between the light-emitting unit 10 in which the wavelength converting part 6 is not formed and the light-emitting unit 10 in which the light-emitting portion of the light-emitting device 4 is covered with the wavelength converting part 6, the directivity angle of the light radiated from the respective light-emitting device 4 is also changed in some cases, in addition to the differences in the light emission color and the color rendering property.

Therefore, the light-emitting unit 10 of the present embodiment can be adjusted by changing the lens shape, etc. of the dome-shaped wavelength converting part 6 in accordance with the content of the fluorescent substance so that the directivity angle of the light radiated from the light-emitting device 4 is not practically changed.

Concavities and convexities having different sizes and angles may be formed on the inner surface of the wavelength converting parts 6 in accordance with the content of the fluorescent substance thereof so that the directivity angle of the light radiated from such light-emitting device 4 is matched even in the case in which any of the wavelength converting parts 6 is provided.

Herein, in the light-emitting unit 10, five light-emitting devices 4 are mounted in the first surface 5a-side of the mounting substrate 5 as the light-emitting devices 4 which radiate the blue light, which is radiated from the LED chips 1 serving as the semiconductor light-emitting elements, to outside without change in order to emit the light of a first color tone (for example, daylight white).

Also, it is conceivable to constitute the light-emitting unit 10 which emits desired white light by carrying out wavelength conversion by the cap-shaped wavelength converting part 6 while using, for example, the blue light radiated from the light-emitting device 4 as a light emission basic color. However, the light-emitting devices 4 has a tendency that wavelength variation or light output variation of the blue light radiated from the LED chip 1, color tone variation generated by the combination with the cap-shaped wavelength converting part 6, which absorbs the blue light and converts it to yellow light serving as a complementary color, and so on become large. Therefore, in the light-emitting device 4 used in the light-emitting unit 10 of the present embodiment, the light-emitting unit 10 is formed so that the light radiated from the light-emitting device 4 uses the mixed-color light radiated from the fluorescent substance as a basic.

At the semiconductor light-emitting element covered with the wavelength converting part 6, the wavelength converting part 6 is formed via air therebetween; therefore, color unevenness can be further reduced by reflection, etc. at the interface of the wavelength converting part 6.

Such a wavelength converting part 6 can be formed to have a desired shape comparatively easily by carrying out molding by, for example, injection molding, wherein the fluorescent substance is mixed in the translucent member such as a silicone resin, epoxy resin, or glass.

### (Second Embodiment)

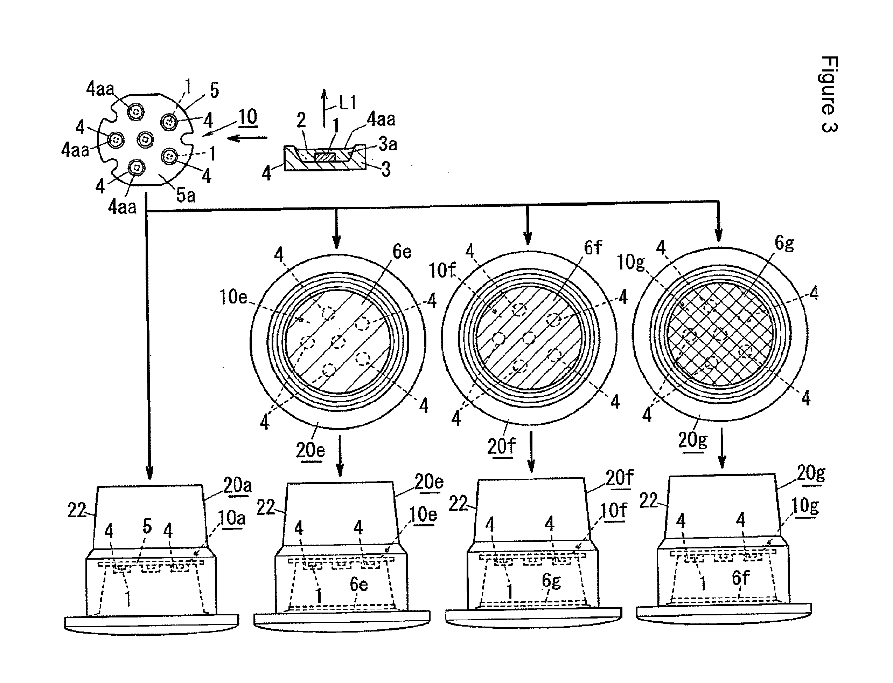

A basic configuration of the illumination device 20 shown in Fig. 2 of the present embodiment is approximately the same configuration as that of the illumination device 20 using the light-emitting unit 10 of the first embodiment shown in Fig. 1; and, as shown in Fig. 3, a different point is that sheet-shaped wavelength converting parts 6e, 6f, and 6g are used instead of the cap-shaped wavelength converting part 6 of the first embodiment. Note that the constituent elements similar to those of the first embodiment are denoted by the same reference numerals, and explanations thereof are arbitrarily omitted.

Along with the directions of arrows for manufacturing the illumination devices 20 of the present embodiment, Fig. 3 shows the light-emitting device 4 of a schematic cross sectional view to the light-emitting unit 10 of a planar view and the light-emitting unit 10 to the light-emitting surfaces and schematic cross sectional views of the illumination devices 10, in which the light-emitting units 10 are housed in the illumination devices 10, respectively.

First, in the light-emitting device 4, the LED chip 1 which can emit blue light is mounted in the concave portion 3a of the package 3, and the light-emitting device 4 is filled with the wavelength converting member 2 so as to cover the LED chip 1. White-based light which is daylight white light L1 is emitted from the light-emitting portion 4aa of the light-emitting device 4.

The light-emitting unit 10 of the present embodiment has the light-emitting device 4, which has the LED chip 1 serving as the semiconductor light-emitting element and emits white-based daylight white light L1, and the mounting substrate 5 on which the light-emitting device 4 is mounted in the first surface 5a-side. Regarding the light-emitting devices 4, the light-emitting devices 4, which emits the same white-based daylight white light L1, are mounted on the first surface 5a of the mounting substrate 5.

Next, in the light-emitting units 10 in each of which the plurality of (herein, six) light-emitting devices 4 on the mounting substrate 5 are mounted, sheet-shaped wavelength converting parts 6e, 6f, and 6g are housed in the fixture main bodies 22 of the illumination devices 20, wherein the wavelength converting parts 6e, 6f, and 6g are separately formed so as to cover the respective light-emitting portions 4aa of the light-emitting devices 4 and emit the light of a correlated color temperature lower than that of the white-based daylight white light L1 emitted respectively from the light-emitting portions 4aa of the light-emitting devices 4.

Herein, the wavelength converting parts 6e, 6f, and 6g are formed to be like sheets; as a result, the illumination devices can be formed, for example, by sandwiching the wavelength converting parts with light-emitting panels (not shown) of the illumination devices 20 without separately covering the plurality of light-emitting devices 4 with the cap-shaped wavelength converting parts 6 of the first embodiment. Therefore, workability for forming the light-emitting units 10 or the illumination device 20 can be significantly improved.

Moreover, the sheet-shaped wavelength converting parts 6e, 6f, and 6g are retained at the positions away from the light-emitting devices 4; therefore, reduction in light emission efficiency can be suppressed without being affected by the adverse affect caused by the heat generation of the light-emitting devices 4, wherein the conversion efficiency at the sheet-shaped wavelength converting parts 6e, 6f, and 6g is reduced. Therefore, the sheet-shaped wavelength converting parts 6e, 6f, and 6g also have the effects of reducing the emitted-light extraction efficiency of the case in which the correlated color temperature of the light radiated from the above described wavelength converting part 6 is reduced to, for example, that based on an incandescent-bulb color and the concentration of the fluorescent substance is increased.

Such a light-emitting unit 10 can constitute the illumination device 20 by superimposing the sheet-shaped wavelength converting part 6e, 6f, or 6g on a translucent panel (not shown), which allows transmission of the light radiated from the light-emitting device 4, and housing them in the fixture main body 22. When a sheet part is formed by bonding the translucent panel of the illumination device 20 with the wavelength converting part 6 or when a printed part composed of the wavelength converting part 6 is formed by a printing method, which is an application of screen printing, is formed, there is also an effect that the color tone can be arbitrarily and freely changed by replacing the translucent panel. Moreover, the application part or the sheet part can be provided with a removed part of the wavelength converting part 6 which allows transmission of white-based light from the light emitting device 4, and a desired figure, pattern, or the like can be arbitrarily formed by the removed part.

### (Third Embodiment)

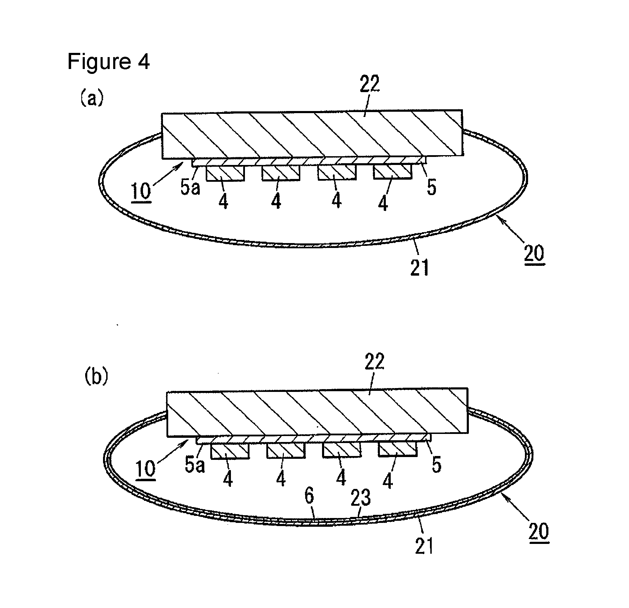

The basic configuration of the illumination devices 20 of the present embodiment shown in Fig. 4 is approximately the same as that of the illumination devices 20 using the light-emitting units 10 of the second embodiment shown in Fig. 3; and, as shown in Fig. 4, a different point is that the wavelength converting part 6 is formed on an inner surface of a globe cover 21, instead of forming the wavelength converting part 6 of the second embodiment on the translucent panel. Note that constituent elements similar to those of the second embodiment are denoted by the same reference numerals, and explanations thereof are arbitrarily omitted.

The illumination device 20 of the present embodiment shown in Fig. 4 (a) is a mode of the illumination device 20 having, for example, a shape like a ceiling light. The illumination device 20 has the light-emitting unit 10 and the fixture main body 22 having the globe cover 21, which allows transmission of light radiated from the light-emitting device 4, wherein the light-emitting unit 10 has the light-emitting device 4, which emits white-based light, and the mounting substrate 5, on which the light-emitting device 4 is mounted in the first surface 5a-side.

The illumination device 20 shown in Fig. 4 (b) has the wavelength converting part 6 which is separately formed on the inner surface of the globe cover 21 of the illumination device 20 shown in Fig. 4 (a) so as to cover the light-emitting device 4 and emits the light of a correlated color temperature lower than that of the white-based light emitted from the light-emitting device 4.

Thus, the illumination device 20 is constituted to use the light-emitting devices 4, which emit white-based light, being mounted in the first surface 5a-side of the mounting substrate 5 as a basic. Moreover, the illumination device 20 shown in Fig. 4 (a) emits white-based light of the basic color tone from the light-emitting device 4 of the light-emitting unit 10 by using the original single-body globe cover 21 not having the wavelength converting part 6. The illumination device 20 shown in Fig. 4 (b) uses the unit of the same type as the light-emitting unit 10 of Fig. 4 (a) and has an application part 23 on which the wavelength converting part 6 is applied on the entire surface of the inner side of the globe cover 21. Similarly, the illumination device may be formed by superimposing a sheet part (not shown) of the wavelength converting part 6 on the entire surface of the inner side of the globe cover 21 instead of the application part 23 on which the wavelength converting part 6 is applied. Thus, the illumination device 20 can emit the light having a correlated color temperature lower than that of the white-based light serving as the basic color tone emitted from the globe cover 21 by the light-emitting device 4.

As well as the illumination device 20 of the second embodiment, the illumination device 20 of the present embodiment has the effect that the correlated color temperature of the light from the illumination device 20 can be changed by, for example, replacing the globe cover 21 or replacing the sheet-shaped wavelength converting part 6. Note that the wavelength converting part 6 is not necessarily formed on the inner surface of the globe cover 21, but may be formed on the outer surface or the interior thereof.

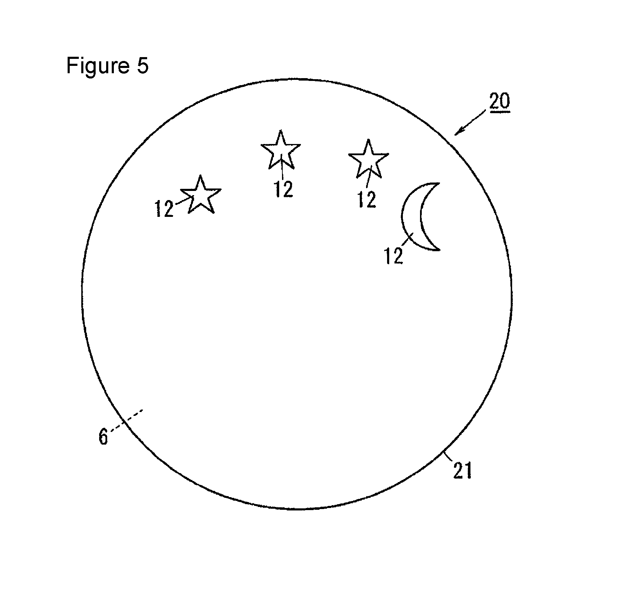

Furthermore, as shown in Fig. 5, in the illumination device 20 of the present embodiment, the application part or the sheet part serving as the wavelength converting part 6 at the globe cover 21 has removed parts 12 of the wavelength converting part 6, which allow transmission of the white-based light from the light-emitting device 4, and the removed parts 12 can form, for example, a star-like or moon figures or patterns. The removed parts 12 may be removed or a non-application part and an arbitrary color tone can be obtained by, for example, separately applying a different fluorescent material thereon. Figures or patterns may be formed by superimposing a plurality of fluorescent substances.

In other words, the surface of the globe cover 21 has the fluorescent member which emits the light having a color tone different from the color tone of the light from the wavelength converting part 6 and the color tone of the light from the light-emitting device 4, and the fluorescent member forms at least either one of figures and patterns. Thus, the illumination device 20 can obtain the light emission of arbitrary figures or patterns, and the illumination device 20 excellent in design can be provided.

### [Description of Reference Numerals]

- 1: Semiconductor light-emitting element (led chip)
- 4: Light-emitting device
- 4aa: Light-emitting portion
- 5: Mounting substrate
- 6: Wavelength converting part
- 9: Fixture main body
- 10: Light-emitting unit
- 12: Removed part
- 20: Illumination device
- 21: Globe cover
- 23: Application part

## Claims

1. A light-emitting unit having a light-emitting device provided with a semiconductor light-emitting element and emitting white-based light and having a mounting substrate, the light-emitting device being mounted on the mounting substrate; the light-emitting unit comprising
a wavelength converting part separately formed so as to cover at least a light-emitting portion of the light-emitting device emitting the white-based light, the wavelength converting part emitting light having a correlated color temperature lower than the correlated color temperature of the white-based light from the light-emitting device.

2. The light-emitting unit according to claim 1, wherein
the white-based light from the light-emitting device is within a range of 4500 K to 7000 K.

3. An illumination device comprising:
a fixture main body provided with a light-emitting unit having a light-emitting device and a mounting substrate, the light-emitting device being mounted on the substrate, the light-emitting device having a semiconductor light-emitting element and emitting white-based light;
a translucent panel or a globe cover allowing transmission of at least part of the light from the light-emitting unit; and
a wavelength converting part separately formed so as to cover at least a light-emitting portion of the light-emitting device emitting the white-based light, the wavelength converting part emitting light having a correlated color temperature lower than the correlated color temperature of the white-based light from the light-emitting device.

4. The illumination device according to claim 3, wherein
the translucent panel or the globe cover is provided with an application part, the wavelength converting part being applied on a surface of the application part.

5. The illumination device according to claim 3, wherein
the translucent panel or the globe cover has a surface, a sheet part of the wavelength converting part being provided on the surface.

6. The illumination device according to claim 4, wherein:
the application part is provided with a removed part of the wavelength converting part, the removed part allowing transmission of the white-based light from the light-emitting device; and
the removed part forms at least one of a figure and a pattern.

7. The illumination device according to claim 5, wherein:
the sheet part is provided with a removed part of the wavelength converting part, the removed part allowing transmission of the white-based light from the light-emitting device; and
the removed part forms at least one of a figure and a pattern.

8. The illumination device according to claim 4 or claim 5, wherein:
the translucent panel or the globe cover has a surface provided with a fluorescent member emitting fluorescence by the color tone of the light from the wavelength converting part and the light from the light emitting device, the fluorescence having a color tone different from the color tone of the light; and
the fluorescent member forms at least one of a figure and a pattern.
